# EUROPÄISCHE PATENTANMELDUNG

(11) **EP 4 506 696 A1**
(43) Veröffentlichungstag der Anmeldung: **12.02.2025**
(21) Anmeldenummer: 23190275.0
(22) Anmeldetag: 08.08.2023
(51) Int. Cl.: G01R 15/24

(54) **VORRICHTUNG ZUR MAGNETO-OPTISCHEN ERMITTLUNG EINES STROMES DURCH EINEN ELEKTRISCHEN LEITER**

(71) Anmelder: Siemens Aktiengesellschaft, 80333 München (DE)
(72) Erfinder: Wetzel, Ulrich, 91325 Adelsdorf (DE)
(74) Vertreter: Siemens Patent Attorneys

(57) **Zusammenfassung**

Die Erfindung betrifft eine Vorrichtung (4) zur magnetooptischen Ermittlung eines Stromes (I) durch einen elektrischen Leiter (6) umfassend eine Lichtquelle (12), welche zur Erzeugung eines Lichtsignals konfiguriert ist, eine Empfangseinheit (16), welche zur Umwandlung des Lichtsignals in ein elektrisches Signal konfiguriert ist, eine Glasspule (8), welche zur Herstellung einer optischen Verbindung zwischen der Lichtquelle (12) und der Empfangseinheit (16) konfiguriert ist und eine Auswerteeinheit (18), welche konfiguriert ist, anhand einer Polarisation des empfangenen Lichtsignals den Strom (I) zu ermitteln. Um eine einfachere Realisierung und die Ermittlung niedrigerer Ströme zu ermöglichen, wird vorgeschlagen, dass die Glasspule (8) als eine planare Spule ausgeführt ist, welche derartig angeordnet ist, dass der elektrische Leiter (6) im Bereich eines Zentrums (24) der planaren Glasspule (8) verlaufend angeordnet ist.

## Beschreibung

Die Erfindung betrifft eine Vorrichtung zur magneto-optischen Ermittlung eines Stromes durch einen elektrischen Leiter.

Ferner betrifft die Erfindung eine Halbleiteranordnung aufweisend zumindest ein Halbleiterelement und eine derartige Vorrichtung.

Des Weiteren betrifft die Erfindung einen Stromrichter mit mindestens einer derartigen Halbleiteranordnung.

Weiterhin betrifft die Erfindung ein Verfahren zur Herstellung einer Vorrichtung, welche zur magneto-optischen Ermittlung eines Stromes durch einen elektrischen Leiter vorgesehen ist.

Darüber hinaus betrifft die Erfindung die Verwendung einer planaren Glasspule zur magneto-optischen Ermittlung eines Stromes durch einen elektrischen Leiter, welcher im Bereich eines Zentrums der planaren Glasspule verlaufend angeordnet ist.

Derartige Halbleiteranordnungen werden beispielsweise in einem Stromrichter in der elektrischen Antriebstechnik eingesetzt. Unter einem Stromrichter ist beispielsweise ein Gleichrichter, ein Wechselrichter, ein Umrichter oder ein Gleichspannungswandler zu verstehen. Derartige Stromrichter sind stetig weiterer Optimierung unterworfen, wodurch es zum Einsatz verbesserter Halbleitermaterialien, geänderter Aufbau und Verbindungstechniken, kurz AVT, sowie verbesserter Entwärmungskonzepte kommt. Darüber hinaus kommen Monitoring-Lösungen zur Überwachung der Halbleitermodule zum Einsatz. Derartige Optimierung zielen insbesondere auf hohe Leistungsdichten, kompakte Bauweisen, hohe Effizienz und gesteigerte Zuverlässigkeit ab.

Die Monitoring-Lösungen umfassen Sensoren, die beispielsweise eine Messung eines Stromes, insbesondere eines Laststromes, ermöglichen. Derartige Sensoren dürfen die Halbleiterelemente und deren Peripherie, welche beispielsweise die AVT, insbesondere Zuleitungen, umfasst, nicht merklich beeinflussen. Ferner ist eine schnelle Reaktion der Sensoren auf dynamische elektrische Vorgänge, insbesondere transiente Schaltvorgänge, der Halbleiterelemente, welche beispielsweise im ms-Bereich oder gar im ps-Bereich liegen, erforderlich.

Die Offenlegungsschrift EP 3 358 359 A1 beschreibt eine Leiterplatte mit einer Leiterbahn aufweisend eine Aussparung, welche derart im Verlauf der Leiterbahn angeordnet ist, dass die Leiterbahn unterbrochen ist, wobei in der Aussparung ein Implantat mit einem linken, rechten, unteren und oberen Rand angeordnet ist, wobei in dem Implantat ein Leiter angeordnet ist, welcher bei eingesetztem Implantat die durch die Aussparung aufgetrennte Leiterbahn schließt, wobei das Implantat eine erste optische Schicht und eine zweite optische Schicht aufweist und der Leiter zwischen den beiden Schichten angeordnet ist, die erste und die zweite optische Schicht weisen jeweils zumindest eine Lichtleitstruktur mit einem ersten Ende und einem zweiten Ende auf, wobei in einem rechten Randbereich des Implantats, in welchen die jeweils zweiten Enden der Lichtleitstrukturen liegen, ein Lichtleitmittel angeordnet ist, damit ein an dem ersten Ende der Lichtleitfaser der ersten optischen Schicht eingespeistes Licht zum zweiten Ende der Lichtleitstruktur der zweiten optische Schicht umgelenkt wird, damit ein Strahlengang des Lichtes den Leiter umschließt, weiterhin aufweisend einen optischen Sender und einen optischen Empfänger mit Auswertemitteln, wodurch ein faseroptischer Stromsensor zur Strommessung eines durch den Leiter fließenden Stromes gebildet wird.

Die Offenlegungsschrift EP 4 050 347 A1 beschreibt ein Verfahren zum Überwachen zumindest eines Halbleiterelements in einem Halbleitermodul, wobei das Halbleitermodul Zuleitungen zur Kontaktierung des Halbleiterelements aufweist. Um dynamische, insbesondere transiente, Vorgänge erfassen zu können, ohne das zumindest eine Halbleiterelement und dessen Peripherie merklich zu beeinflussen, wird vorgeschlagen, dass ein magneto-optischer Sensor im Bereich des Halbleiterelements oder zumindest einer Zuleitung angeordnet ist, wobei ein polarisiertes Lichtsignal vom magneto-optischen Sensor reflektiert wird, wobei anhand einer Polarisation des reflektierten Lichtsignals ein Strom ermittelt wird.

Die wissenschaftliche Publikation "Development of Optical current Transformers and Application to Fault Location Systems for Substations " Y. Yamagata et al, IEEE Transactions on Power Delivery, Vol. 8, No. 3, July 1993, Seiten 1 bis 7 beschreibt einen magnetooptischen Stromwandler, der ein Faraday-Element aus einem als Wismutsiliciumoxid (BSO)-Einkristall ausgebildeten Volumenelement enthält. Der Offenbarungsgehalt der wissenschaftlichen Publikation wird durch Verweisung in die vorliegende Anmeldung mit einbezogen.

Bisherige Lösungen mittels magneto-optischer Sensoren sind aufwändig in der Realisierung und auf Messung von hohen Strömen bzw. elektrischen Feldern beschränkt, was einen breiten industriellen Einsatz zumindest erschwert.

Vor diesem Hintergrund besteht die Aufgabe der vorliegenden Erfindung darin, eine Vorrichtung zur magneto-optischen Ermittlung eines Stromes durch einen elektrischen Leiter mittels magneto-optischer Sensorik anzugeben, welche einfach zu realisieren und zur Ermittlung niedrigerer Ströme geeignet ist.

Die Aufgabe wird erfindungsgemäß gelöst durch eine Vorrichtung zur magneto-optischen Ermittlung eines Stromes durch einen elektrischen Leiter umfassend: eine Lichtquelle, welche zur Erzeugung eines Lichtsignals konfiguriert ist, eine Empfangseinheit, welche zur Umwandlung des Lichtsignals in ein elektrisches Signal konfiguriert ist, eine Glasspule, welche zur Herstellung einer optischen Verbindung zwischen der Lichtquelle und der Empfangseinheit konfiguriert ist und eine Auswerteeinheit, welche konfiguriert ist, anhand einer Polarisation des empfangenen Lichtsignals den Strom zu ermitteln, wobei die Glasspule als eine planare Spule ausgeführt ist, welche derartig angeordnet ist, dass der elektrische Leiter im Bereich eines Zentrums der planaren Glasspule verlaufend angeordnet ist.

Ferner wird die Aufgabe erfindungsgemäß gelöst durch eine Vorrichtung zur magneto-optischen Ermittlung eines Stromes durch einen elektrischen Leiter umfassend: eine Lichtquelle, welche zur Erzeugung eines Lichtsignals konfiguriert ist, einen Reflektor, welcher konfiguriert ist, das von der Lichtquelle erzeugte Lichtsignal zu reflektieren eine Glasspule, welche zur Herstellung einer optischen Verbindung zwischen der Lichtquelle und dem Reflektor konfiguriert ist, eine Empfangseinheit, welche zur Umwandlung des vom Reflektor reflektierten Lichtsignals in ein elektrisches Signal konfiguriert ist und eine Auswerteeinheit, welche konfiguriert ist, anhand einer Polarisation des empfangenen Lichtsignals den Strom zu ermitteln, wobei die Glasspule als eine planare Spule ausgeführt ist, welche derartig angeordnet ist, dass der elektrische Leiter im Bereich eines Zentrums der planaren Glasspule verlaufend angeordnet ist.

Des Weiteren wird die Aufgabe erfindungsgemäß gelöst durch eine Halbleiteranordnung aufweisend zumindest ein Halbleiterelement, welches mit einem elektrischen Leiter verbunden ist, und eine derartige Vorrichtung.

Weiterhin wird die Aufgabe erfindungsgemäß gelöst durch einen Stromrichter mit mindestens einer derartigen Halbleiteranordnung.

Weiterhin wird die Aufgabe erfindungsgemäß gelöst durch ein Verfahren zur Herstellung einer Vorrichtung, welche zur magneto-optischen Ermittlung eines Stromes durch einen elektrischen Leiter vorgesehen ist, umfassend: eine Lichtquelle, welche zur Erzeugung eines Lichtsignals konfiguriert ist, eine Empfangseinheit, welche zur Umwandlung des Lichtsignals in ein elektrisches Signal konfiguriert ist, eine Auswerteeinheit, welche konfiguriert ist, anhand einer Polarisation des empfangenen Lichtsignals den Strom zu ermitteln und eine Glasspule, wobei die Glasspule zur Herstellung einer optischen Verbindung mit der Lichtquelle und der Empfangseinheit verbunden wird, wobei die Glasspule zur Herstellung einer optischen Verbindung mit der Lichtquelle und der Empfangseinheit verbunden wird, wobei die Glasspule als eine planare Spule ausgeführt wird, welche derartig angeordnet wird, dass der elektrische Leiter im Bereich eines Zentrums der planaren Glasspule verläuft.

Weiterhin wird die Aufgabe erfindungsgemäß gelöst durch ein Verfahren zur Herstellung einer Vorrichtung, welche zur magneto-optischen Ermittlung eines Stromes durch einen elektrischen Leiter vorgesehen ist, umfassend eine Lichtquelle, welche zur Erzeugung eines Lichtsignals konfiguriert ist, einen Reflektor, eine Empfangseinheit, welche zur Umwandlung des vom Reflektor reflektierten Lichtsignals in ein elektrisches Signal konfiguriert ist, eine Auswerteeinheit, welche konfiguriert ist, anhand einer Polarisation des empfangenen Lichtsignals den Strom zu ermitteln und eine Glasspule, wobei die Glasspule zur Herstellung einer optischen Verbindung mit der Lichtquelle und dem Reflektor verbunden wird, wobei die Glasspule zur Herstellung einer optischen Verbindung mit der Lichtquelle und dem Reflektor verbunden wird, wobei die Glasspule als eine planare Spule ausgeführt wird, welche derartig angeordnet wird, dass der elektrische Leiter im Bereich eines Zentrums der planaren Glasspule verläuft.

Darüber hinaus wird die Aufgabe erfindungsgemäß gelöst durch die Verwendung einer planaren Glasspule zur magneto-optischen Ermittlung eines Stromes durch einen elektrischen Leiter, welcher im Bereich eines Zentrums der planaren Glasspule verlaufend angeordnet ist.

Die in Bezug auf die Vorrichtung nachstehend angeführten Vorteile und bevorzugten Ausgestaltungen lassen sich sinngemäß auf die Halbleiteranordnung, den Stromrichter, das Herstellungsverfahren und die Verwendung übertragen.

Der Erfindung liegt die Überlegung zugrunde, eine sensorbasierte Überwachung eines Halbleiterelements zu verbessern, indem ein magneto-optischer Sensors zur galvanisch getrennten Ermittlung eines Stromes, insbesondere in einem Halbleitermodul, verwendet wird, der eine Glasspule aufweist, wobei durch eine große Nähe der Glasspule zu einem stromdurchflossenen elektrischen Leiter und eine ausreichend hohe Anzahl von Windungen der Glasspule die Ermittlung niedrigerer Ströme, insbesondere für den Niedervoltbereich, ermöglicht wird. Aufgrund magneto-optischer Effekte, welche bei einer Transmission Faraday Effekt und bei einer Reflexion Kerr-Effekt genannt werden, sind Magnetfelder dadurch, insbesondere quantitativ, erfassbar, dass in der Glasspule eine Polarisationsänderung verursacht wird, welche von der Feldstärke des Magnetfeldes abhängig ist. Um eine für die Sensorik optimierte Anordnung zu erreichen und diese einfach realisieren zu können, wird die Glasspule planar ausgeführt, wobei der elektrische Leiter im Bereich eines Zentrums der planaren Glasspule verlaufend angeordnet ist. Derartige planare Glasspulen sind unter anderem auf einer elektro-optischen Leiterplatte, kurz EOCB, einfach und kompakt realisierbar. Beispielsweise weist die planare Glasspule mindestens 5 Windungen, insbesondere mindestens 10 Windungen, auf.

Die Strommessung kann als Reflexions- oder Transmissionsmessung realisiert werden, wobei für eine Reflexionsmessung zusätzlich ein Reflektor, welcher beispielsweise als Spiegel ausgeführt ist, mit der planaren Glasspule verbunden wird. Eine Lichtquelle zur Erzeugung eines Lichtsignals und eine Empfangseinheit zur Umwandlung des reflektierten oder transmittierten Lichtsignals in ein elektrisches Signal werden mit der planaren Glasspule verbunden. Eine Auswerteeinheit ist konfiguriert, anhand einer Polarisation des empfangenen Lichtsignals den zu messenden Strom durch den elektrischen Leiter zu ermitteln.

Eine weitere Ausführungsform sieht vor, dass die planare Glasspule in einer Ebene angeordnet ist, welche im Wesentlichen senkrecht zum elektrischen Leiter verlaufend angeordnet ist. Dies führt zu einer optimierten Ausrichtung der planaren Glasspule zum Magnetfeld des stromdurchflossenen elektrischen Leiters, was sich positiv auf die Empfindlichkeit der Sensorik auswirkt.

Eine weitere Ausführungsform sieht vor, dass die planare Glasspule, insbesondere vollständig, in ein Substrat integriert ist. Beispielsweise ist die planare Glasspule vollständig in dem Substrat angeordnet und schließt bündig mit einer Substratoberfläche ab, sodass die Anordnung eine ebene Oberfläche aufweist. Eine Integration der Glasspule in das Substrat ist einfach zu realisieren und ermöglicht eine präzise platzsparende Bauweise.

Eine weitere Ausführungsform sieht vor, dass eine von der planaren Glasspule definierte Ebene parallel zu einer Oberfläche des Substrats angeordnet ist. Dies führt zu einer optimierten Ausrichtung der planaren Glasspule zum Magnetfeld des stromdurchflossenen elektrischen Leiters, was sich positiv auf die Empfindlichkeit der Sensorik auswirkt. Ferner ist eine derartige Anordnung einfach zu realisieren.

Eine weitere Ausführungsform sieht vor, dass die planare Glasspule aus Wellenleitern aufgebaut ist, welche eine Breite im Bereich von 1 µm bis 100 µm, insbesondere 3 µm bis 50 µm, aufweisen. Derartige Strukturen ermöglichen eine hohe Zahl an Wicklungen auf engstem Raum, was eine große Nähe der planaren Glasspule zum stromdurchflossenen elektrischen Leiter ermöglicht und somit zu einer erhöhten Empfindlichkeit führt.

Eine weitere Ausführungsform sieht vor, dass die Wellenleiter der planaren Glasspule, insbesondere mittels eines Diffusionsprozesses, in Kavitäten des Substrats eingebracht sind. Insbesondere sind die optischen Wellenleiter mit Hilfe eines geführten Laserstrahls und anschließendem Ionenaustauschprozess in Dünnglas herstellbar. Beispielsweise ist die planare Glasspule vollständig in Kavitäten des Substrats eingebracht und schließt planbündig mit einer Substratoberfläche ab, sodass die Anordnung eine ebene Oberfläche aufweist. Insbesondere mittels eines Diffusionsprozesses sind feine Strukturen mit einer hohen Zahl an Wicklungen auf engstem Raum realisierbar.

Eine weitere Ausführungsform sieht vor, dass der elektrische Leiter eine Durchkontaktierung im Substrat umfasst, welche im Bereich des Zentrums der planaren Glasspule verlaufend angeordnet ist. Beispielsweise verläuft die Durchkontaktierung senkrecht zu einer Oberfläche des Substrats, in welchem die planare Glasspule angeordnet ist. Dies führt zu einer optimierten Ausrichtung des Magnetfeldes im Bereich der Durchkontaktierung des elektrischen Leiters im Verhältnis zur die Durchkontaktierung umgebenden planaren Glasspule.

Eine weitere Ausführungsform sieht vor, dass die planare Glasspule ein Quarzglas, einem Flintglas, Wismutsiliciumoxid und/oder Wismutgermaniumoxid enthält. Dies führt zu einer ausreichend hohen Verdet-Konstante der planaren Glasspule, sodass eine genügend empfindliche Strommessgenauigkeit, insbesondere für den Niedervoltbereich, erreicht wird.

Im Folgenden wird die Erfindung anhand der in den Figuren dargestellten Ausführungsbeispiele näher beschrieben und erläutert.

Es zeigen:
FIG 1 eine schematische Darstellung einer Halbleiteranordnung mit einer ersten Ausgestaltung einer Vorrichtung zur magneto-optischen Ermittlung eines Stromes durch einen elektrischen Leiter,
FIG 2 eine schematische Schnittdarstellung einer ersten Ausgestaltung einer Vorrichtung zur magneto-optischen Ermittlung eines Stromes durch einen elektrischen Leiter,
FIG 3 eine schematische Darstellung einer Halbleiteranordnung mit einer zweiten Ausgestaltung einer Vorrichtung zur magneto-optischen Ermittlung eines Stromes durch einen elektrischen Leiter,
FIG 4 eine schematische Darstellung einer Halbleiteranordnung mit einer dritten Ausgestaltung einer Vorrichtung zur magneto-optischen Ermittlung eines Stromes durch einen elektrischen Leiter,
FIG 5 eine schematische Darstellung eines Stromrichters mit einem Halbleitermodul.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

Gleiche Bezugszeichen haben in den verschiedenen Figuren die gleiche Bedeutung.

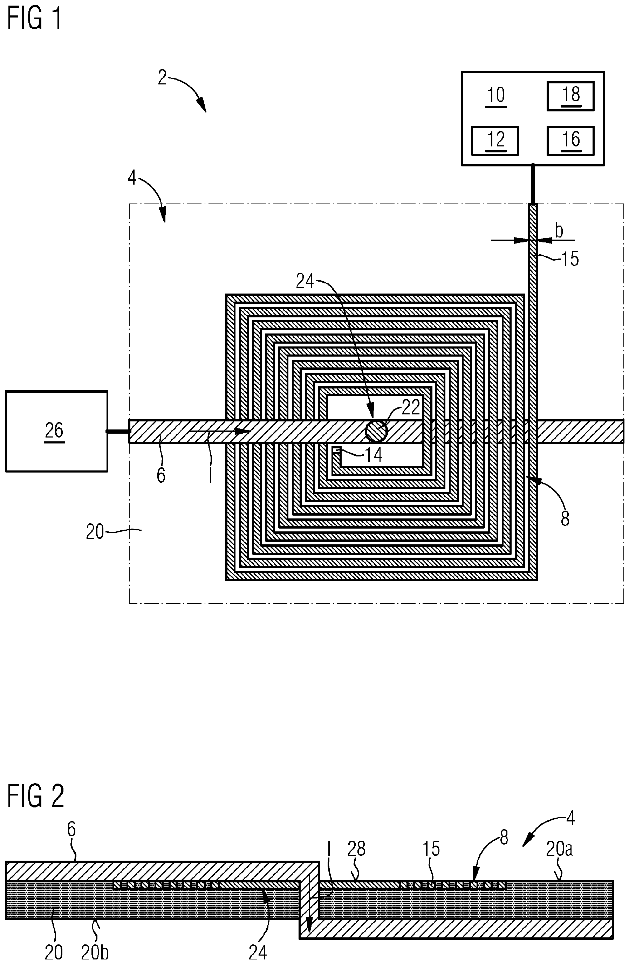

FIG 1 zeigt eine schematische Darstellung einer Halbleiteranordnung 2 mit einer ersten Ausgestaltung einer Vorrichtung 4 zur magneto-optischen Ermittlung eines Stromes I durch einen elektrischen Leiter 6. Die Vorrichtung 4 umfasst eine, beispielhaft rechteckige, Glasspule 8, die als eine planare Spule ausgeführt ist, sowie eine mit der planaren Glasspule 8 verbundene Sende- und Empfangseinheit 10. Die Sende- und Empfangseinheit 10 umfasst eine Lichtquelle 12 zur Erzeugung eines Lichtsignals. Die planare Glasspule 8 ist mit einem Reflektor 14 verbunden, welcher konfiguriert ist, das von der Lichtquelle 12 erzeugte Lichtsignal zu reflektieren. Beispielsweise weist der Reflektor 14 einen Spiegel auf. Über die planare Glasspule 8 wird eine optische Verbindung zwischen der Lichtquelle 12 und dem Reflektor 14 hergestellt. Beispielsweise ist die planare Glasspule 8 aus Wellenleitern 15 aufgebaut, welche eine Breite (b) im Bereich von 1 µm bis 100 µm, insbesondere 3 µm bis 50 µm, aufweisen.

Die planare Glasspule 8 ist beispielsweise aus einem Dünnglas hergestellt, welches ein Quarzglas, einem Flintglas, Wismutsiliciumoxid und/oder Wismutgermaniumoxid enthält, sodass eine ausreichend hohe Verdet-Konstante erreicht wird, um eine genügend empfindliche Strommessgenauigkeit, insbesondere für den Niedervoltbereich, bereitzustellen. Die Sende- und Empfangseinheit 10 umfasst überdies eine Empfangseinheit 16, welche zur Umwandlung des vom Reflektor 14 reflektierten Lichtsignals in ein elektrisches Signal konfiguriert ist, sowie eine Auswerteeinheit 18, welche konfiguriert ist, anhand einer Polarisation des empfangenen Lichtsignals einen Strom I durch den elektrischen Leiter 6 zu ermitteln.

Die planare Glasspule 8 ist, insbesondere vollständig, in ein Substrat 20 integriert. Das Substrat kann unter anderem als elektro-optische Leiterplatte, kurz EOCB, ausgeführt sein. Die Wellenleiter 15 der planaren Glasspule 8 sind mittels eines Diffusionsprozesses, in Kavitäten des Substrats 20 eingebracht. Insbesondere sind optische Wellenleiter 15 mit Hilfe eines geführten Laserstrahls und anschließendem Ionenaustausch-prozess in Dünnglas herstellbar. Mit Hilfe eines Lasers können komplexe Wellenleiter-Geometrien abgebildet werden. Somit ist eine hohe Zahl an Wicklungen auf engstem Raum herstellbar. Die in FIG 1 dargestellte planare Glasspule 8 weist aus Gründen der einfacheren Darstellbarkeit exemplarisch 8,5 Windungen auf, wobei, insbesondere mittels des Diffusionsprozesses, deutlich mehr Windungen realisierbar sind, was zu einer verbesserten Empfindlichkeit führt. Beispielsweise weist die planare Glasspule 8 mindestens 5 Windungen, insbesondere mindestens 10 Windungen auf.

Der elektrische Leiter 6 ist auf dem Substrat 20 angeordnet und weist eine Durchkontaktierung 22 auf, die beispielsweise als Via ausgeführt und zumindest teilweise durch das Substrat 20 verlaufend angeordnet ist. Die Durchkontaktierung 22 ist im Bereich des Zentrums 24 der planaren Glasspule 8 angeordnet, sodass die Durchkontaktierung 22 des elektrischen Leiters 6 dicht an den optischen Wellenleitern 15 der planaren Glasspule 8 vorbeiführt wird. Somit ist das Magnetfeld gegenüber der Wellen-Propagation des Lichtes im optischen Wellenleiters immer gleich ausgerichtet und moduliert. Somit verläuft die Polarisation in eine Richtung. Die planare Glasspule 8 ist dabei so gestaltet, dass über die gesamte Länge der Wellenleiter 15 der Spule ohne Zuleitungen, abgesehen vom Faraday-Effekt, Polarisationstreue, d.h. keine Änderungen der Polarisation, vorliegt. Der Reflektor 14 hat an dieser Stelle den Vorteil, dass durch den doppelten Lichtweg die doppelte Modulationslänge vorliegt. Ferner wird die Ein- bzw. Auskopplung vereinfacht.

Die Halbleiteranordnung 2 weist darüber hinaus zumindest ein Halbleiterelement 26 auf, welches mit dem elektrischen Leiter 6 verbunden ist. Das Halbleiterelement 26 kann unter anderem als ein Insulated-Gate-Bipolar-Transistor (IGBT) oder als ein anderer Leistungshalbleiter, beispielsweise als ein Leistungshalbleiter mit breiter Bandlücke, insbesondere ein GaN oder SiC Leistungshalbleiter, ausgeführt sein. Beispielsweise fließt über den elektrischen Leiter 6 ein Laststrom des Halbleiterelements 26, welcher über die Vorrichtung 4 ermittelt wird.

FIG 2 zeigt eine schematische Schnittdarstellung einer ersten Ausgestaltung einer Vorrichtung 4 zur magneto-optischen Ermittlung eines Stromes I durch einen elektrischen Leiter 6. Die planare Glasspule 8 ist vollständig im Substrat 20 integriert, es steht also kein Wellenleiter 15 der planaren Glasspule 8 über eine Oberfläche 20a, 20b des Substrats 20 über. Die Durchkontaktierung 22 des elektrischen Leiters 6 verläuft von einer ersten Oberfläche 20a zu einer der ersten Oberfläche 20a gegenüberliegenden zweiten Oberfläche 20b des Substrats 20. Alternativ kann die Durchkontaktierung 22 als "blind via" mit einer Innenlage des Substrats 20 verbunden sein. Eine von der planaren Glasspule 8 definierte Ebene 28 ist parallel zu den Oberflächen 20a, 20b des Substrats 20 verlaufend angeordnet, wobei die Ebene 28, in welcher die planare Glasspule 8 angeordnet ist, im Wesentlichen senkrecht zur Durchkontaktierung 22 des elektrischen Leiters 6 verläuft. Die weitere Ausführung der Vorrichtung 4 in FIG 2 entspricht der in FIG 1.

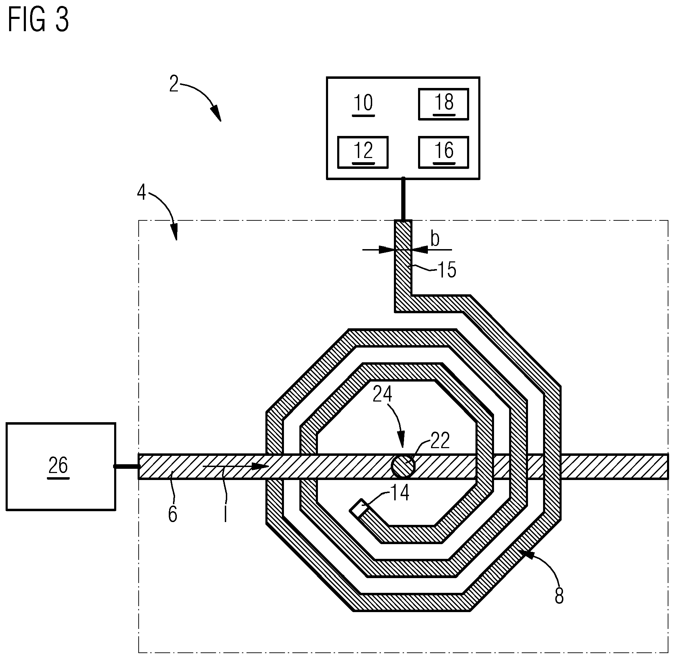

FIG 3 zeigt eine schematische Darstellung einer Halbleiteranordnung 2 mit einer zweiten Ausgestaltung einer Vorrichtung 4 zur magneto-optischen Ermittlung eines Stromes I durch einen elektrischen Leiter 6. Die planare Glasspule 8 ist oktogonal ausgeführt. Alternativ kann die planare Glasspule 8 unter anderem hexagonal oder rund ausgeführt sein. Dies hat zur Folge, dass die Durchkontaktierung 22 des elektrischen Leiters 6 dicht an den optischen Wellenleitern 15 der planaren Glasspule 8 vorbeiführt wird. Die in FIG 3 dargestellte oktogonal ausgeführte planare Glasspule 8 weist aus Gründen der einfacheren Darstellbarkeit exemplarisch 2,5 Windungen auf, wobei, wie oben beschrieben, deutlich mehr Windungen realisierbar sind. Die weitere Ausführung der Vorrichtung 4 in FIG 3 entspricht der in FIG 1.

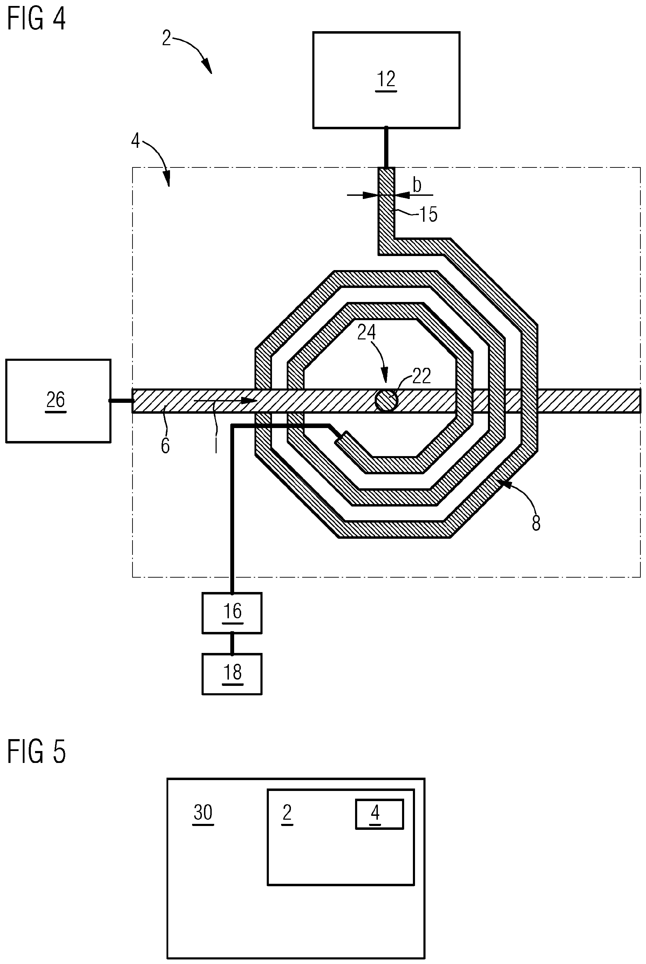

FIG 4 zeigt eine schematische Darstellung einer Halbleiteranordnung 2 mit einer dritten Ausgestaltung einer Vorrichtung 4 zur magneto-optischen Ermittlung eines Stromes I durch einen elektrischen Leiter 6. Die Empfangseinheit 16 ist an einem der Lichtquelle 12 gegenüberliegenden Ende der planare Glasspule 8 angeordnet. Somit stellt die planare Glasspule 8 eine optische Verbindung zwischen der Lichtquelle 12 und der Empfangseinheit 16 her. Die Empfangseinheit 16 ist zur Umwandlung des transmittierten Lichtsignals in ein elektrisches Signal konfiguriert. Die Auswerteeinheit 18 ist konfiguriert anhand einer Polarisation des empfangenen Lichtsignals den Strom zu ermitteln. Die Empfangseinheit 16 kann unmittelbar am Ende der planare Glasspule 8 auf dem Substrat 20 angeordnet sein. Alternativ kann die planare Glasspule 8 über einen zusätzlichen Wellenleiter mit dem Rand des Substrats 20 verbunden werden. Ein- und Auskoppelflächen sind damit über präzise Anlagenkanten, beispielsweise auf Träger-Lagen einer EOCB, mit der Lichtquelle 12 und der Empfangseinheit 16 verbindbar. Die weitere Ausführung der Vorrichtung 4 in FIG 4 entspricht der in FIG 3.

FIG 5 zeigt eine schematische Darstellung eines Stromrichters 30 mit einer Halbleiteranordnung 2. Die Halbleiteranordnung 2 umfasst eine Vorrichtung 4 zur magneto-optischen Ermittlung eines Stromes durch einen elektrischen Leiter. Der Stromrichter 30 kann mehr als eine Halbleiteranordnung 2 umfassen.

Zusammenfassend betrifft die Erfindung eine Vorrichtung 4 zur magneto-optischen Ermittlung eines Stromes I durch einen elektrischen Leiter 6 umfassend eine Lichtquelle 12, welche zur Erzeugung eines Lichtsignals konfiguriert ist, eine Empfangseinheit 16, welche zur Umwandlung des Lichtsignals in ein elektrisches Signal konfiguriert ist, eine Glasspule 8, welche zur Herstellung einer optischen Verbindung zwischen der Lichtquelle 12 und der Empfangseinheit 16 konfiguriert ist und eine Auswerteeinheit 18, welche konfiguriert ist, anhand einer Polarisation des empfangenen Lichtsignals den Strom I zu ermitteln. Um eine einfachere Realisierung und die Ermittlung niedrigerer Ströme zu ermöglichen, wird vorgeschlagen, dass die Glasspule 8 als eine planare Spule ausgeführt ist, welche derartig angeordnet ist, dass der elektrische Leiter 6 im Bereich eines Zentrums 24 der planaren Glasspule 8 verlaufend angeordnet ist.

## Patentansprüche

1. Vorrichtung (4) zur magneto-optischen Ermittlung eines Stromes (I) durch einen elektrischen Leiter (6) umfassend:
- eine Lichtquelle (12), welche zur Erzeugung eines Lichtsignals konfiguriert ist,
- eine Empfangseinheit (16), welche zur Umwandlung des Lichtsignals in ein elektrisches Signal konfiguriert ist,
- eine Glasspule (8), welche zur Herstellung einer optischen Verbindung zwischen der Lichtquelle (12) und der Empfangseinheit (16) konfiguriert ist,
- eine Auswerteeinheit (18), welche konfiguriert ist, anhand einer Polarisation des empfangenen Lichtsignals den Strom (I) zu ermitteln,
wobei die Glasspule (8) als eine planare Spule ausgeführt ist,
welche derartig angeordnet ist, dass der elektrische Leiter (6) im Bereich eines Zentrums (24) der planaren Glasspule (8) verlaufend angeordnet ist.

2. Vorrichtung (4) zur magneto-optischen Ermittlung eines Stromes (I) durch einen elektrischen Leiter (6) umfassend:
- eine Lichtquelle (12), welche zur Erzeugung eines Lichtsignals konfiguriert ist,
- einen Reflektor (14), welcher konfiguriert ist, das von der Lichtquelle (12) erzeugte Lichtsignal zu reflektieren
- eine Glasspule (8), welche zur Herstellung einer optischen Verbindung zwischen der Lichtquelle (12) und dem Reflektor (14) konfiguriert ist,
- eine Empfangseinheit (16), welche zur Umwandlung des vom Reflektor (14) reflektierten Lichtsignals in ein elektrisches Signal konfiguriert ist,
- eine Auswerteeinheit (18), welche konfiguriert ist, anhand einer Polarisation des empfangenen Lichtsignals den Strom (I) zu ermitteln
wobei die Glasspule (8) als eine planare Spule ausgeführt ist,
welche derartig angeordnet ist, dass der elektrische Leiter (6) im Bereich eines Zentrums (24) der planaren Glasspule (8) verlaufend angeordnet ist.

3. Vorrichtung (4) nach einem der Ansprüche 1 oder 2,
wobei die planare Glasspule (8) in einer Ebene (28) angeordnet ist, welche im Wesentlichen senkrecht zum elektrischen Leiter (6) verlaufend angeordnet ist.

4. Vorrichtung (4) nach einem der vorherigen Ansprüche,
wobei die planare Glasspule (8), insbesondere vollständig, in ein Substrat (20) integriert ist.

5. Vorrichtung (4) nach Anspruch 4,
wobei die planare Glasspule (8) aus Wellenleitern (15) aufgebaut ist, welche eine Breite (b) im Bereich von 1 µm bis 100 µm, insbesondere 3 µm bis 50 µm, aufweisen.

6. Vorrichtung (4) nach einem der Ansprüche 4 oder 5,
wobei die Wellenleiter (15) der planaren Glasspule (8), insbesondere mittels eines Diffusionsprozesses, in Kavitäten des Substrats (20) eingebracht sind.

7. Vorrichtung (4) nach einem der Ansprüche 4 bis 6,
wobei der elektrische Leiter (6) eine Durchkontaktierung (22) im Substrat (20) umfasst, welche im Bereich des Zentrums (24) der planaren Glasspule (8) verlaufend angeordnet ist.

8. Vorrichtung (4) nach einem der vorherigen Ansprüche, wobei die planare Glasspule (8) ein Quarzglas, einem Flintglas, Wismutsiliciumoxid und/oder Wismutgermaniumoxid enthält.

9. Halbleiteranordnung (2) aufweisend zumindest ein Halbleiterelement (26), welches mit einem elektrischen Leiter (6) verbunden ist, und eine Vorrichtung (4) nach einem der vorherigen Ansprüche.

10. Stromrichter (30) mit mindestens einer Halbleiteranordnung (2) nach Anspruch 9.

11. Verfahren zur Herstellung einer Vorrichtung (4), welche zur magneto-optischen Ermittlung eines Stromes (I) durch einen elektrischen Leiter (6) vorgesehen ist, umfassend:
- eine Lichtquelle (12), welche zur Erzeugung eines Lichtsignals konfiguriert ist,
- eine Empfangseinheit (16), welche zur Umwandlung des Lichtsignals in ein elektrisches Signal konfiguriert ist,
- eine Auswerteeinheit (18), welche konfiguriert ist, anhand einer Polarisation des empfangenen Lichtsignals den Strom (I) zu ermitteln,
- eine Glasspule (8),
wobei die Glasspule (8) zur Herstellung einer optischen Verbindung mit der Lichtquelle (12) und der Empfangseinheit (16) verbunden wird,
wobei die Glasspule (8) als eine planare Spule ausgeführt wird, welche derartig angeordnet wird, dass der elektrische Leiter (6) im Bereich eines Zentrums (24) der planaren Glasspule (8) verläuft.

12. Verfahren zur Herstellung einer Vorrichtung (4), welche zur magneto-optischen Ermittlung eines Stromes (I) durch einen elektrischen Leiter (6) vorgesehen ist, umfassend:
- eine Lichtquelle (12), welche zur Erzeugung eines Lichtsignals konfiguriert ist,
- einen Reflektor (14),
- eine Empfangseinheit (16), welche zur Umwandlung des vom Reflektor (14) reflektierten Lichtsignals in ein elektrisches Signal konfiguriert ist,
- eine Auswerteeinheit (18), welche konfiguriert ist, anhand einer Polarisation des empfangenen Lichtsignals den Strom (I) zu ermitteln,
- eine Glasspule (8),
wobei die Glasspule (8) zur Herstellung einer optischen Verbindung mit der Lichtquelle (12) und dem Reflektor (14) verbunden wird,
wobei die Glasspule (8) als eine planare Spule ausgeführt wird, welche derartig angeordnet wird, dass der elektrische Leiter (6) im Bereich eines Zentrums (24) der planaren Glasspule (8) verläuft.

13. Verfahren nach einem der Ansprüche 11 oder 12,
wobei die planare Glasspule (8) in einer Ebene (28) angeordnet wird, welche im Wesentlichen senkrecht zum elektrischen Leiter (6) verläuft.

14. Verfahren nach einem der Ansprüche 11 bis 13,
wobei die planare Glasspule (8), insbesondere vollständig, in ein Substrat (20) integriert wird.

15. Verfahren nach Anspruch 14,
wobei die planare Glasspule (8) aus Wellenleitern (15) aufgebaut wird, welche eine Breite (b) im Bereich von 1 µm bis 100 µm, insbesondere 3 µm bis 50 µm, aufweisen.

16. Verfahren nach einem der Ansprüche 14 oder 15,
wobei die Wellenleiter (15) der planaren Glasspule (8), insbesondere mittels eines Diffusionsprozesses, in Kavitäten des Substrats (20) eingebracht werden.

17. Verfahren nach einem der Ansprüche 14 bis 16,
wobei der elektrische Leiter (6) eine Durchkontaktierung (22) im Substrat (20) umfasst, welche im Bereich des Zentrums (24) der planaren Glasspule (8) verlaufend angeordnet wird.

18. Verfahren nach einem der Ansprüche 11 bis 17,
wobei die planare Glasspule (8) aus einem Werkstoff hergestellt wird, welcher ein Quarzglas, einem Flintglas, Wismutsiliciumoxid oder Wismutgermaniumoxid enthält.

19. Verwendung einer planaren Glasspule (8) zur magneto-optischen Ermittlung eines Stromes (I) durch einen elektrischen Leiter (6), welcher im Bereich eines Zentrums (24) der planaren Glasspule (8) verlaufend angeordnet ist.

20. Verwendung nach Anspruch 19,
wobei die planare Glasspule (8) in einer Ebene (28) angeordnet ist, die im Wesentlichen senkrecht zum elektrischen Leiter (6) verlaufend angeordnet ist.

21. Verwendung nach einem der Ansprüche 19 oder 20,
wobei die planare Glasspule (8), insbesondere vollständig, derartig in ein Substrat (20) integriert ist, dass eine von der planaren Glasspule (8) definierte Ebene (28) parallel zu einer Oberfläche (20a, 20b) des Substrats (20) angeordnet ist.
